# EUROPEAN PATENT APPLICATION

(11) **EP 4 513 863 A1**
(43) Date of publication of application: **26.02.2025**
(21) Application number: 23856118.7
(22) Date of filing: 27.04.2023
(51) Int. Cl.: H04M 1/18, H04M 1/02

(54) **MIDDLE FRAME ASSEMBLY AND ELECTRONIC DEVICE COMPRISING SAME**

(30) Priority: 24.08.2022 CN 202211021156
(71) Applicant: Honor Device Co., Ltd., Shenzhen, Guangdong 518040 (CN)
(72) Inventor: PING, Linquan, Shenzhen, Guangdong 518040 (CN); DI, Xijian, Shenzhen, Guangdong 518040 (CN); MA, Zhe, Shenzhen, Guangdong 518040 (CN); YAO, Wenxing, Shenzhen, Guangdong 518040 (CN)
(74) Representative: Isarpatent
(86) International application number: PCT/CN2023/091362
(87) International publication number: WO 2024/041024

(57) **Abstract**

Disclosed are a middle frame assembly and an electronic device including same. The middle frame assembly includes an inner frame and an outer frame arranged on an outer periphery of the inner frame, where the inner frame includes a first metal material, the outer frame includes a second metal material, and a density of the first metal material is lower than a density of the second metal material. According to the present disclosure, a weight of the middle frame assembly can be reduced, and further, a weight of the electronic device can be reduced, thereby improving portability, and keeping an appearance of the electronic device with a high-grade gloss and feel.

## Description

This application claims priority to Chinese Patent Application No. 202211021156.9, filed with the China National Intellectual Property Administration on August 24, 2022 and entitled "MIDDLE FRAME ASSEMBLY AND ELECTRONIC DEVICE INCLUDING SAME", which is incorporated herein by reference in its entirety.

### TECHNICAL FIELD

The present disclosure relates to a middle frame assembly and an electronic device including same, and more specifically, to a middle frame assembly with a reduced weight and an electronic device including same.

### BACKGROUND

With the popularization of portable electronic devices, weights of the electronic devices have major impact on portability of the electronic devices. For example, mobile phones are portable electronic devices currently most frequently used by consumers. A weight of a mobile phone is a key factor affecting portability of the mobile phone, and reducing the weight of the mobile phone is always a direction of making efforts in continuous iteration of mobile phone products. How to further reduce a weight of an electronic device, such as a mobile phone, has become key difficulty in opening up the consumer market. A weight of a middle frame assembly accounts for 20% to 30% of an overall weight of an electronic device such as a mobile phone. Therefore, reducing the weight of the middle frame assembly has a significant benefit in reducing the weight of the entire electronic device.

Common solutions of reducing the weight of the middle frame assembly include the following two:
1. Reduce a volume of a structural member:
   The middle frame assembly is prepared by directly using an aluminum alloy, and an interior of the aluminum alloy of the middle frame assembly is filled with a plastic layer, to achieve an antenna clearance effect. To reduce a weight, the middle frame assembly is partially hollowed out and thinned. However, this solution affects strength of the structural member, which further affects overall strength, and its weight reduction effect is limited.
2. Replace with a material with a lower density:
   The middle frame assembly is manufactured by directly replacing an aluminum alloy die-cast member with a die-cast member of a lightweight alloy such as a magnesium alloy or a zinc alloy. A plastic layer is wrapped around an exterior and an interior of the die-cast member, to achieve an antenna clearance effect. A paint is sprayed on the plastic wrapped around the exterior of the middle frame assembly, to achieve an appearance effect of the middle frame assembly. However, none of the existing lightweight alloys, such as a magnesium alloy and a zinc alloy, can achieve an appearance with a high-grade metallic texture of an aluminum alloy profile. Therefore, such a process cannot be applied to a high-end electronic device such as a flagship mobile phone.

### SUMMARY

Therefore, an objective of the present disclosure is to provide a middle frame assembly that can reduce a weight while keeping an appearance presenting a high-grade gloss and feel.

Another object of the present disclosure is an electronic device including the foregoing middle frame assembly.

Other features and advantages of the present disclosure will be described later in the specification, and will be partially apparent from the following in the specification. These advantages and other advantages of the present disclosure are achieved by using structures specifically pointed out in the specification, claims, and accompanying drawings.

To achieve the foregoing objectives, according to an implementation of the present disclosure, a middle frame assembly is disclosed, including an inner frame and an outer frame arranged on an outer periphery of the inner frame, where the inner frame includes a first metal material, the outer frame includes a second metal material, and a density of the first metal material is lower than a density of the second metal material. Therefore, a weight of the middle frame assembly can be reduced, conductivity of the middle frame assembly can be ensured, mechanical strength of the middle frame assembly can be improved, and heat can be dissipated better.

In some implementations, the density of the first metal material is lower than or equal to 70% of the density of the second metal material, which can further effectively reduce the weight of the middle frame assembly.

In some implementations, the first metal material of the inner frame includes one or more selected from a magnesium alloy, a zinc alloy, and a copper alloy. The magnesium alloy, the zinc alloy, and the copper alloy are common lightweight metals, so that a weight of the middle frame assembly can be effectively reduced, sufficient mechanical strength and heat dissipation of the middle frame assembly can be ensured, and good electrical conductivity of the middle frame assembly, used as an antenna or the like, can be further ensured. In particular, when the magnesium alloy is used, the weight of the middle frame assembly is further effectively reduced, and the sufficient strength of the inner frame can also be ensured.

In some implementations, the second metal material of the outer frame includes one or more selected from an aluminum alloy, stainless steel, and a titanium alloy. The aluminum alloy, the stainless steel, and the titanium alloy each have a higher density and higher strength and an appearance that can present a high-grade gloss and feel through surface treatment. When being used, the aluminum alloy has a density lower than those of the stainless steel and the titanium alloy, and a low price. Therefore, it can be ensured that the appearance presents a high-grade gloss and feel, the weight of the middle frame assembly can also be reduced, and in addition, manufacturing costs can be reduced. When being used, compared with the aluminum alloy, the stainless steel can improve the mechanical strength of the middle frame assembly, and the appearance can achieve a higher-grade gloss and feel. When being used, compared with the stainless steel, the titanium alloy can reduce the weight of the middle frame assembly while improving the mechanical strength of the middle frame assembly.

In some implementations, the second metal material is arranged on an outer surface of the outer frame. Therefore, the second metal material is exposed on the outer surface of the electronic device, to enable the middle frame assembly and even the electronic device to present an appearance with a high-grade gloss and feel.

In some implementations, one or both of the inner frame and the outer frame is a single-layer frame. The inner frame and the outer frame are each of a simple single-layer structure, which not only can reduce the weight of the middle frame assembly, but also can make the structure of the middle frame assembly more reliable, facilitate production, and make it easier to mount the middle frame assembly to the electronic device.

In some implementations, one or both of the inner frame and the outer frame is a laminated frame having a multi-layer structure. In this way, the inner frame or the outer frame is of a split multi-layer structure, can be used in various structures of electronic devices, and can satisfy different design requirements, thereby improving flexibility of mounting the middle frame assembly to the electronic device.

In some implementations, an adhesive layer is arranged between the inner frame and the outer frame. Through the structure, the inner frame and the outer frame can be reliably bonded.

In some implementations, a part at which the inner frame and the outer frame have a height difference is arranged in a ramp shape, and the adhesive layer is arranged on the ramp-shaped part. Through the structure, the part at which the inner frame and the outer frame with the height difference can perform transition, so that the adhesive layer can be smoothly and reliably filled into the gap at the part with the height difference with the help of its own flowability.

In some implementations, the inner frame and the outer frame are fastened by a fastening member. Through the structure, the inner frame and the outer frame can be firmly fixed.

In some implementations, the fastening member is a locking screw, at least one of the inner frame and the outer frame is provided with a through hole, and the fastening member passes through the through hole to fix the inner frame and the outer frame. Through the structure, the inner frame and the outer frame can be firmly fixed.

In some implementations, one of the inner frame and the outer frame is provided with the through hole, the other of the inner frame and the outer frame is provided with a threaded hole, and the fastening member passes through the through hole and is fastened into the threaded hole. Through the structure, firm fixing can be performed by using a few components, and a process is simple.

In some implementations, a conductive member electrically connecting the outer frame and the inner frame is provided between the outer frame and the inner frame. The conductive member can electrically connect the outer frame to the inner frame stably, thereby achieving a stable electrical connection.

In some implementations, the conductive member is an elastic piece, and the elastic piece includes an elastic piece base and an elastic piece probe extending from the elastic piece base, where the elastic piece base is in contact with one of the inner frame and the outer frame, and the elastic piece probe is in contact with the other of the inner frame and the outer frame.

In some implementations, the elastic piece base is welded to the one of the inner frame and the outer frame, and the elastic piece probe abuts against the other of the inner frame and the outer frame.

In some implementations, the conductive member is a gasket, and the gasket includes a gasket body and a gasket elastic arm extending from the gasket body, where a gasket bump is arranged on at least one of an upper surface and a lower surface of the gasket body, and the gasket bump is arranged on at least one of an upper surface and a lower surface of the gasket elastic arm; and the gasket is sandwiched between the inner frame and the outer frame through a fastening member, the gasket body and the gasket elastic arm surround the fastening member, and the gasket bump abuts against at least one of the inner frame and the outer frame.

In some implementations, the gasket bumps are arranged on the upper surfaces and the lower surfaces of the gasket body and the gasket elastic arm, and abut against the inner frame and the outer frame respectively, and the gasket bumps are arranged at different positions respectively on the upper surfaces of the gasket body and the gasket elastic arm and the lower surfaces of the gasket body and the gasket elastic arm; or the gasket bumps are arranged on only the upper surfaces of the gasket body and the gasket elastic arm, and the lower surface of the gasket body on which no gasket bump is arranged is welded to the inner frame or the outer frame; or the gasket bumps are arranged on only the lower surfaces of the gasket body and the gasket elastic arm, and the upper surface of the gasket body on which no gasket bump is arranged is welded to the inner frame or the outer frame.

In some implementations, the conductive member is a connecting piece, and the connecting piece includes a first arm, a second arm spaced apart from the first arm by a gap and opposite to the first arm, and a connecting portion connecting the first arm and the second arm, where first arm and the second arm respectively extend from the connecting portion, the first arm is connected to the inner frame, and the second arm is connected to the outer frame.

In some implementations, in a region connected to the connecting piece, the inner frame has a recessed portion or a protruding portion, and the outer frame has a protruding portion or a recessed portion interlocked with the recessed portion or the protruding portion.

According to an implementation of the present disclosure, an electronic device includes the foregoing middle frame assembly. Therefore, a weight of the middle frame assembly can be reduced, and further, a weight of the electronic device can be reduced, thereby improving portability.

According to an implementation of the present disclosure, an electronic device includes the foregoing middle frame assembly; a structural member of the electronic device; and a fastening member, where the inner frame and the outer frame are combined with the structural member by the fastening member. Because the structural member of the electronic device is used, the inner frame, the outer frame, and the structural member can be fastened more firmly through the fastening member. In addition, because the inner frame and the outer frame are fixed by using the structural member of the electronic device, and the structural member is usually provided with a mounting hole, addition of an unnecessary procedure is avoided, a machining process can be simplified, and costs can also be reduced.

In some implementations, one of the inner frame and the outer frame and the structural member are provided with through holes, the other of the inner frame and the outer frame is provided with a threaded hole, and the fastening member passes through the through holes and is fastened into the threaded hole. Because the structural member of the electronic device is used, the inner frame, the outer frame, and the structural member can be fastened more firmly through the fastening member.

In some implementations, the structural member is provided with a threaded hole, the inner frame and the outer frame are both provided with through holes, and the fastening member passes through the through holes and is fastened into the threaded hole. Because the structural member of the electronic device is used, the inner frame, the outer frame, and the structural member can be fastened more firmly through the fastening member.

In some implementations, one of the inner frame and the outer frame has a concave portion, and the other of the inner frame and the outer frame has a convex portion interlocked with the concave portion; and at least one of the inner frame and the outer frame is fastened to the structural member by the fastening member, and one of the concave portion and the convex portion is clamped between the structural member and the other of the concave portion and the convex portion.

In some implementations, the structural member includes a plurality of stacked structural members, and the inner frame and the outer frame are fastened to the plurality of structural members by the fastening member.

In some implementations, the structural member is a support structural member, a rotating shaft structural member, or a PCB board. Because the structural member fastened to the middle frame member may be various structural member of the electronic device such as a support structural member, a rotating shaft structural member, or a PCB board, fastening manners are diversified according to different structural members and fastened parts, thereby increasing flexibility of fastening between the middle frame assembly and the structural member.

According to an implementation of the present disclosure as described above, a middle frame assembly that can reduce a weight while keeping an appearance presenting a high-grade gloss and feel and an electronic device including same can be provided.

### BRIEF DESCRIPTION OF DRAWINGS

The accompanying drawings are used to provide a further understanding of the present disclosure, constitute a part of this specification, and are used, together with implementations of the present disclosure, to explain the present disclosure, but do not constitute limitations to the present disclosure. In the accompanying drawings:
FIG. 1 is a schematic diagram of a mobile phone according to an implementation of the present disclosure;
FIG. 2 is an exploded view of a mobile phone according to an implementation of the present disclosure;
FIG. 3 is an exploded plan view of a middle frame assembly according to an implementation of the present disclosure;
FIG. 4 is a schematic diagram of a middle frame assembly after assembly according to an implementation of the present disclosure;
FIG. 5A and FIG. 5B are schematic diagrams of an adhesive layer of a middle frame assembly according to an implementation of the present disclosure, where FIG. 5A shows a disassembled state of an inner frame, an outer frame, and an adhesive layer, and FIG. 5B shows an assembled state of an inner frame, an outer frame, and an adhesive layer;
FIG. 6A and FIG. 6B are cross-sectional views taken along a line A-A' in FIG. 5B, where FIG. 6A shows a state in which no adhesive layer is arranged, and FIG. 6B shows a state in which an adhesive layer is arranged.
FIG. 7 is a schematic diagram of mounting of a fastening member of a middle frame assembly according to an implementation of the present disclosure;
FIG. 8 is a plan view of an example of a fastening member of a middle frame assembly according to an implementation of the present disclosure;
FIG. 9A is a cross-sectional view taken along a line B-B' in FIG. 8;
FIG. 9B is a cross-sectional view taken along a line C-C' in FIG. 8;
FIG. 9C is a cross-sectional view taken along a line D-D' in FIG. 8;
FIG. 9D is a schematic diagram of another connection manner of a fastening member according to an implementation of the present disclosure;
FIG. 9E is a schematic diagram of still another connection manner of a fastening member according to an implementation of the present disclosure;
FIG. 10 is a schematic diagram of an elastic piece according to an implementation of the present disclosure;
FIG. 11 is a schematic diagram of an elastic piece being mounted between an inner frame and an outer frame according to an implementation of the present disclosure;
FIG. 12 is a schematic diagram of a gasket according to an implementation of the present disclosure;
FIG. 13 is a schematic diagram of a gasket being mounted between an inner frame and an outer frame according to an implementation of the present disclosure;
FIG. 14 is a schematic diagram of a connecting piece according to an implementation of the present disclosure; and
FIG. 15 is a schematic diagram a connecting piece being mounted between an inner frame and an outer frame according to an implementation of the present disclosure.

### DESCRIPTION OF EMBODIMENTS

The following clearly and completely describes the technical solutions in implementations of the present disclosure with reference to accompanying drawings in implementations of the present disclosure. Apparently, the described implementations are merely some rather than all implementations of the present disclosure All other implementations obtained by a person of ordinary skill in the art based on implementations of the present disclosure without creative efforts shall fall within the protection scope of the present disclosure.

Terms used in the following implementations are only intended to describe particular implementations, and are not intended to limit the present disclosure. As used in this specification and the appended claims of the present disclosure, a singular expression form, "one", "a", "the", "the foregoing", "this", or "the one", is intended to also include the expression form such as "one or more", unless clearly indicated to the contrary in the context. It should be further understood that, in implementations of the present disclosure, "one or more" means one, two, or more than two.

Reference to "one implementation", "some implementations", or the like described in this specification means that a specific feature, structure, or characteristic described with reference to this implementation is included in one or more implementations of the present disclosure. Therefore, statements, such as "in one implementation", "in some implementations", "in other implementations", and "in some other implementations", in differences in this specification do not necessarily refer to the same implementation, but mean "one or more but not all implementations", unless otherwise specifically emphasized in another way. The terms "include", "comprise", "have" and their variations mean "including but not limited to", unless otherwise specifically emphasized in another way.

In addition, in implementations of the present disclosure, a term, such as the word "exemplary" or "for example", is used to represent giving an example, an illustration, or a description. Any implementation or design scheme described with the term "exemplary" or "for example" in the implementations of the present disclosure should not be explained as being more preferred or having more advantages than another implementation or design scheme. Exactly, use of the term, such as "exemplary" or "for example", is intended to present a related concept in a specific manner.

In the present disclosure, when a positional relationship is described, if the positional relationship between two components is described as "on", "above", "under", or the like, one or more other components may be further arranged between the two components unless a more restrictive term, for example, "immediately adjacent, is used

It should be understood that although the terms, such as "first" and "second", may be used in this specification to describe various elements, the elements should not be limited by the terms. The terms are merely used to distinguish one element from another element. For example, without departing from the scope of this disclosure, a first element may also be denoted as a second element. Similarly, a second element may also be denoted as a first element.

As can be fully understood by a person skilled in the art, features of various implementations of the present disclosure may be partially or entirely integrated or combined with each other, and may be associated in a plurality of manners. The implementations of the present disclosure may be implemented independently of each other or may be implemented in combination.

The present disclosure is further described below with reference to the accompanying drawings and specific implementations.

According to some implementations of the present disclosure, a middle frame assembly is provided. The middle frame assembly is mounted on an electronic device. The electronic device may be any device having communication and storage functions, for example, a smartphone, a cellular phone, a cordless phone, a session initiation protocol (session initiation protocol, SIP) phone, a tablet computer, a personal digital assistant (personal digital assistant, PDA), a notebook computer, a digital camera, an e-book reader, a portable multimedia player, a handheld device having a wireless communication function, a computing device or another processing device connected to a wireless modem, an in-vehicle device, a wearable device, or a 5G terminal device. This is not limited in the present disclosure.

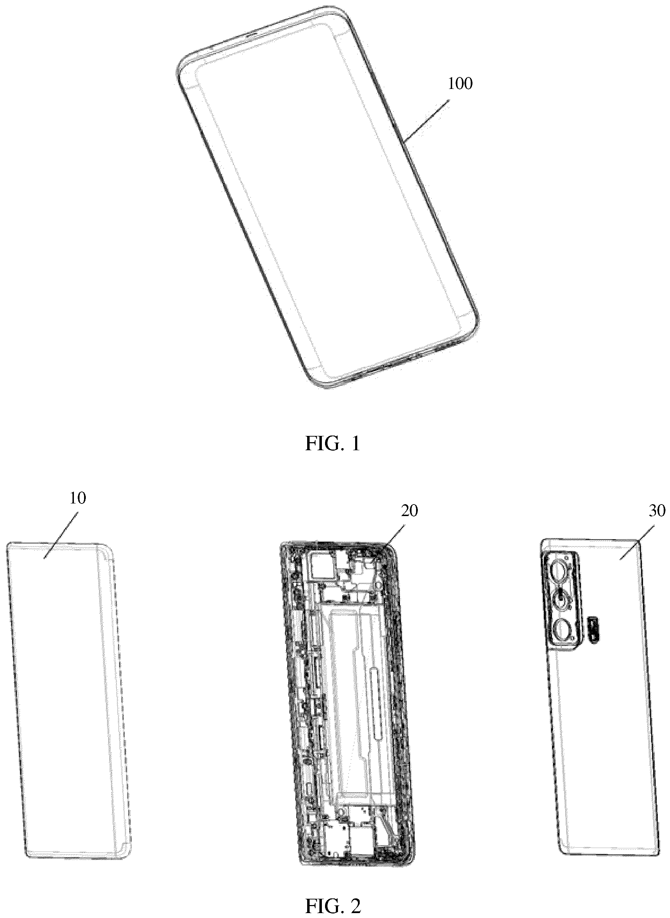

For a better understanding of the present disclosure, referring to FIG. 1 and FIG. 2, an electronic device in an implementation of the present disclosure is described by using a mobile phone 100 as an example, but the present disclosure is not limited thereto. The middle frame assembly of the present disclosure may be used in any of the foregoing electronic devices.

FIG. 1 is a schematic diagram of a mobile phone 100 according to an implementation of the present disclosure, and FIG. 2 is an exploded view of the mobile phone 100 according to an implementation of the present disclosure.

In FIG. 1 and FIG. 2, the mobile phone 100 may include a display screen 10, a middle frame assembly 20, and a rear cover 30. The middle frame assembly 20 is located between the display screen 10 and the rear cover 30.

The display screen 10 forms a display surface of the mobile phone 100, and is configured to display information such as an image, a text, and a video, and provide information exchanging. The display screen 10 may be a light-emitting diode display screen, a liquid crystal display screen, or the like, but is not limited thereto. The display screen 10 may be a flexible screen having a bending characteristic, that is, a foldable screen, or may be a rigid display screen.

The rear cover 30 forms a rear housing of the mobile phone 100. The rear cover 30 is configured to protect electronic components in the mobile phone 100 from water and dust, and ensure a clean appearance of the mobile phone 100. The rear cover 30 may be made of a conductive material, such as metal, or a non-conductive material such as glass or plastic. When the rear cover 30 is made of a conductive material such as metal, the rear cover 30 may be used as a reference ground of an electronic component or a radio frequency component in the mobile phone 100.

An accommodating cavity configured to accommodate electronic components, such as a printed circuit board and a battery, may be formed between the rear cover 30 and the middle frame assembly 20.

The printed circuit board is an important component of the mobile phone 100, and various components, such as a circuit, a processor, a chip, a capacitor, a resistor, an inductor, an interface, and a plug-in, that form a circuit system of the mobile phone 100 are mounted on the printed circuit board. Optionally, an integrated circuit chip, a power management unit chip, a radio frequency chip, or the like may be arranged on the printed circuit board. In addition, various processors, such as a central processing unit, various application processors, a graphics processing unit, or an image signal processor, are usually further arranged on the printed circuit board, but the present disclosure is limited thereto.

The battery is arranged in a battery compartment of the accommodating cavity. The battery is an energy storage tool providing power to the mobile terminal. The battery may be a lithium battery, a nickel-hydrogen battery, a sodium-ion battery, or the like.

In addition, the structure illustrated in implementations of the present disclosure does not constitute a specific limitation on the mobile phone 100. The mobile phone 100 may include more or fewer components than those shown in FIG. 1 and FIG. 2, or some components may be combined, or some components may be split, or components are arranged in different manners. For example, the mobile phone 100 may further include a camera, including a front-facing camera, a rear-facing camera, and components such as a flash.

The mobile phone in implementations of the present disclosure may be a foldable mobile phone or a bar mobile phone, which is not specifically limited.

Next, referring to FIG. 2 to FIG. 15, the middle frame assembly 20 of implementations of the present disclosure is described in detail.

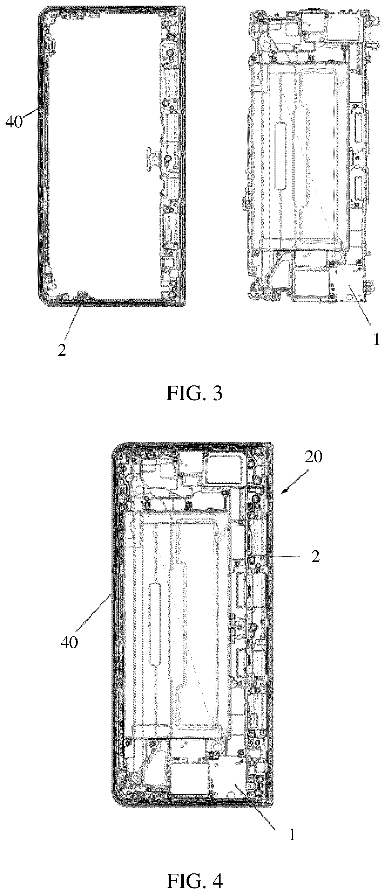

FIG. 3 is an exploded plan view of the middle frame assembly 20 according to an implementation of the present disclosure. FIG. 4 is a schematic diagram of the middle frame assembly 20 after assembly according to an implementation of the present disclosure. Referring to FIG. 2 to FIG. 4, the present disclosure provides a middle frame assembly 20, including an inner frame 1 and an outer frame 2 arranged on an outer periphery of the inner frame 1. Alternatively, the inner frame 1 may also be referred to as an inner plate.

The inner frame 1 includes a first metal material, the outer frame 2 includes a second metal material. The inner frame 1 and the outer frame 2 are respectively made of metal materials, so that conductivity of the middle frame assembly 20 can be ensured, mechanical strength of the middle frame assembly 3 can be improved, and heat can be better dissipated.

A density of the first metal material of the inner frame 1 is lower than a density of the second metal material of the outer frame 2. That is, the first metal material of the inner frame 1 is a lightweight metal, such as a lightweight alloy, and the second metal material of the outer frame 2 is a metal with a higher density such as an alloy, so that a weight of the middle frame assembly 20 can be reduced, and further, a weight of the electronic device can be reduced, thereby improving portability.

In some implementations, a volume occupied by the inner frame 1 is greater than a volume occupied by the outer frame 2. The inner frame 1 is made of the first metal material whose density is less than that of the second metal material of the outer frame 1, so that the weight of the middle frame assembly 20 can be greatly reduced, and further, the weight of the electronic device can be greatly reduced, thereby greatly improving portability.

In some implementations, a shape of the outer frame 2 may be an approximately rectangular frame shape. Correspondingly, a shape of the inner frame 1 may be an approximately rectangular plate shape, but is not limited thereto. The shapes of the inner frame 1 and the outer frame 2 may be arbitrarily set according to design requirements.

In some implementations, the density of the first metal material of the inner frame 1 is lower than or equal to 70% of the density of the second metal material of the outer frame 2, which can further effectively reduce the weight of the middle frame assembly. If the density of the first metal material of the inner frame 1 is greater than 70% of the density of the second metal material of the outer frame 2, a density difference between the first metal material of the inner frame 1 and the density of the second metal material of the outer frame 2 is not large, the weight of the middle frame assembly cannot be effectively reduced, and it is meaningless to arrange the inner frame 1 and the outer frame 2 that are two different layers of metals.

In some implementations, the first metal material of the inner frame 1 may include one or more selected from a magnesium alloy, a zinc alloy, and a copper alloy. The magnesium alloy, the zinc alloy, and the copper alloy are common lightweight metals, so that a weight of the middle frame assembly can be effectively reduced, sufficient mechanical strength and heat dissipation of the middle frame assembly can be ensured, and good electrical conductivity of the middle frame assembly, used as an antenna or the like, can be further ensured. In particular, when the magnesium alloy is used, the weight of the middle frame assembly is further effectively reduced, and the sufficient strength of the inner frame can also be ensured. However, a material of the first metal material of the inner frame 1 is not limited to the foregoing materials provided that the first metal material is a lightweight alloy with a density lower than that of the second metal material of the outer frame 2.

For example, the magnesium alloy may be AZ91D or AM60B.

In the AZ91D magnesium alloy, a content of Al ranges from 8.5% to 9.5%, a content of Mn ranges from 0.17% to 0.4%, a content of Cu is less than or equal to 0.025%, a content of Fe is less than or equal to 0.004%, a content of Si is less than or equal to 0.05%, a content of Zn ranges from 0.45% to 0.90%, a content of Ni is less than or equal to 0.001%, and the balance is Mg. A density of the AZ91D magnesium alloy is about 1.82 g/cm³.

In the AM60B magnesium alloy, a content of Al ranges from 5.6% to 6.4%, a content of Mn ranges from 0.26% to 0.50%, a content of Cu is less than or equal to 0.008%, a content of Fe is less than or equal to 0.004%, a content of Si is less than or equal to 0.05%, a content of Zn is less than or equal to 0.20%, a content of Ni is less than or equal to 0.001%, and the balance is Mg. A density of the AZ91D magnesium alloy is about 1.8 g/cm³.

However, the foregoing AZ91D or AM60B is merely an example of the magnesium alloy, but the present disclosure is not limited thereto. Provided that the magnesium alloy used in the first metal material of the inner frame 1 is a lightweight alloy, components of the magnesium alloy are not specifically limited.

Alternatively, the zinc alloy and the copper alloy may have various components provided that the zinc alloy and the copper alloy are lightweight alloys with a density lower than that of the second metal material of the outer frame 2. In addition, to improve strength of the middle frame assembly 20 and enable the middle frame assembly 20 to have a high-grade gloss and feel, in some implementations, the second metal material of the outer frame 2 may include one or more selected from an aluminum alloy, stainless steel, and a titanium alloy. The aluminum alloy, the stainless steel, and the titanium alloy each have a high density and high strength, thereby ensuring the strength of the middle frame assembly 20. In addition, the aluminum alloy, the stainless steel, and the titanium alloy can present a high-grade gloss and feel after surface treatment, so that the middle frame assembly 20 and further, the mobile phone 100 can present a high-grade gloss and feel. When being used, the aluminum alloy has a density lower than those of the stainless steel and the titanium alloy, and a low price. Therefore, it can be ensured that the appearance presents a high-grade gloss and feel, the weight of the middle frame assembly can also be reduced, and in addition, manufacturing costs can be reduced. When being used, compared with the aluminum alloy, the stainless steel can improve the mechanical strength of the middle frame assembly, and the appearance can achieve a higher-grade gloss and feel. When being used, compared with the stainless steel, the titanium alloy can reduce the weight of the middle frame assembly while improving the mechanical strength of the middle frame assembly.

As shown in FIG. 3, FIG. 4, FIG. 5A, and FIG. 5B, the second metal material of the outer frame 2 may be arranged on an outer surface 40 of the outer frame 2. Therefore, the second metal material is exposed on the outer surface 40 of the electronic device, to enable the middle frame assembly and even the electronic device to present an appearance with a high-grade gloss and feel.

In some implementations, one or both of the inner frame 1 and the outer frame 2 may be a single-layer frame. One or both of the inner frame and the outer frame are of a single-layer frame, which not only can reduce the weight of the middle frame assembly, but also can make the structure of the middle frame assembly more reliable, facilitate production, and make it easier to mount the middle frame assembly to the electronic device.

Alternatively, in some implementations, one or both of the inner frame 1 and the outer frame 2 may be a laminated frame having a multi-layer structure. In this way, the inner frame or the outer frame is of a split multi-layer structure, can be used in various structures of electronic devices, and can satisfy different design requirements, thereby improving flexibility of mounting the middle frame assembly to the electronic device.

In some implementations, the inner frame 1 and the outer frame 2 may be formed separately instead of integrally forming the inner frame 1 and the outer frame 2 by, for example, injection molding. If the inner frame 1 and the outer frame 2 are integrally formed by, for example, injection molding, because shapes of the inner frame 1 and the outer frame 2 are not completely regular, there may be a gap between the inner frames 1 and 2, making it difficult to completely seal the inner frame 1 and the outer frame 2, which may result in corrosion of internal components of the mobile phone 100. Separately formed structures make it convenient to subsequently perform separate sealing between the inner frame and the outer frame, thereby avoiding a problem that complete sealing cannot be achieved through integral forming.

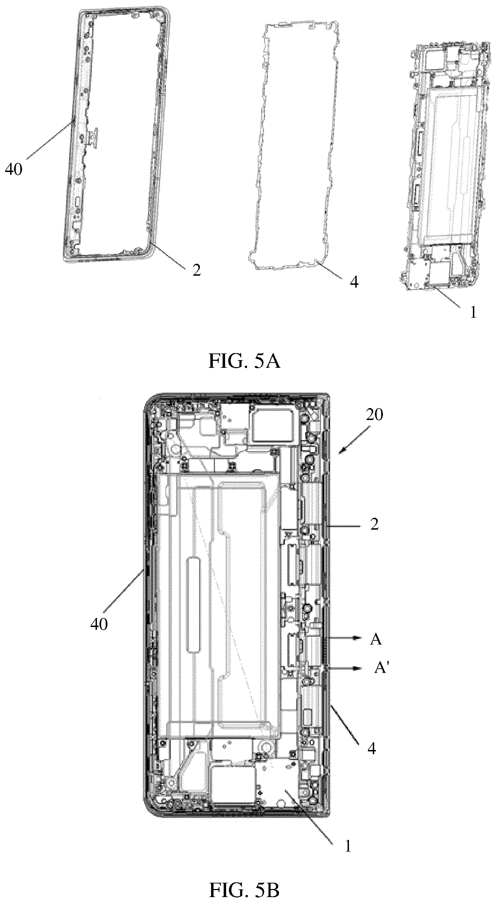

FIG. 5A and FIG. 5B are schematic diagrams of an adhesive layer of a middle frame assembly according to an implementation of the present disclosure, where FIG. 5A shows a disassembled state of an inner frame, an outer frame, and an adhesive layer, and FIG. 5B shows an assembled state of an inner frame, an outer frame, and an adhesive layer. To reliably bond the inner frame 1 and the outer frame 2, an adhesive layer 4 is arranged between the inner frame 1 and the outer frame 2.

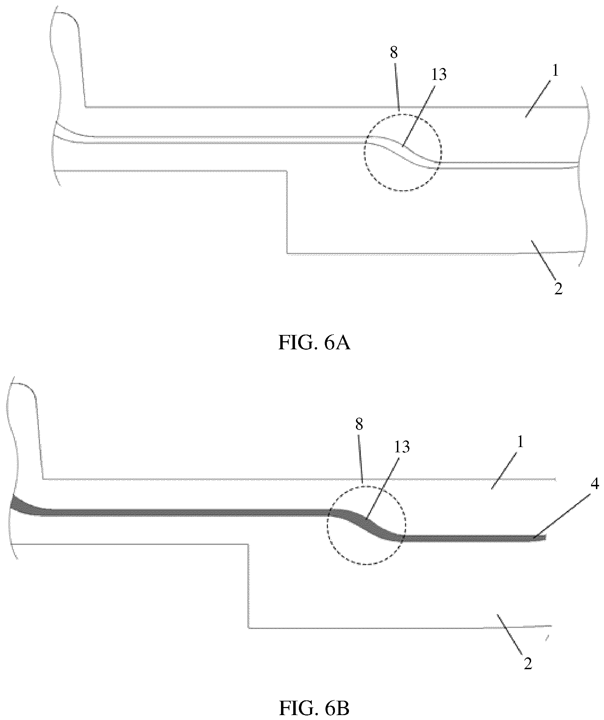

FIG. 6A and FIG. 6B are cross-sectional views taken along a line A-A' in FIG. 5B, where FIG. 6A shows a state in which no adhesive layer is arranged, and FIG. 6B shows a state in which an adhesive layer is arranged. When the inner frame 1 and the outer frame 2 are combined together, there may be a gap 13 between the inner frame 1 and the outer frame 2, and the adhesive layer 4 is coated on a joint between the inner frame 1 and the outer frame 2 to seal the inner frame 1 and the outer frame 2. Preferably, the adhesive layer 4 closes all gaps between the inner frame 1 and the outer frame 2. Therefore, the inner frame 1 and the outer frame 2 can be tightly sealed by the adhesive layer 4.

For example, the adhesive layer may be coated by dispensing, but is not limited thereto, or the adhesive layer may be coated in another manner.

Further, because the shapes of the inner frame 1 and the outer frame 2 may not be completely regular, there may be a height difference at the joint between the inner frame 1 and the outer frame 2, and the joint of the inner frame 1 and the outer frame 2 usually has a step shape. However, such a step shape may prevent the adhesive layer from being completely coated smoothly.

Therefore, as shown in FIG. 6A, a part 8 at which the inner frame 1 and the outer frame 2 have a height difference may be arranged in a ramp shape instead of a conventional step shape, so that the part at which the inner frame 1 and the outer frame 2 have the height difference can perform transition. Referring to FIG. 6B, the adhesive layer 4 is arranged between the inner frame 1 and the outer frame 2. When the adhesive layer 4 is applied by, for example, dispensing, compared with the conventional step shape, the adhesive layer 4 can be smoothly and reliably filled into the ramp-shaped part 8 with the help of its own flowability, thereby ensuring that the adhesive layer 4 can be filled into a gap at which the inner frame 1 and the outer frame 2 have a height difference. In addition, the adhesive layer 4 is also filled into a gap 13 in another region between the inner frame 1 and the outer frame 2.

Therefore, the adhesive layer 4 can completely seal the gap 13, so that the middle frame assembly 20 can be sealed, to prevent corrosion of internal components of the mobile phone 100.

Preferably, as shown in FIG. 6A and FIG. 6B, the ramp shape at the part 8 may be a ramp shape having a smooth curve shape, but is not limited thereto.

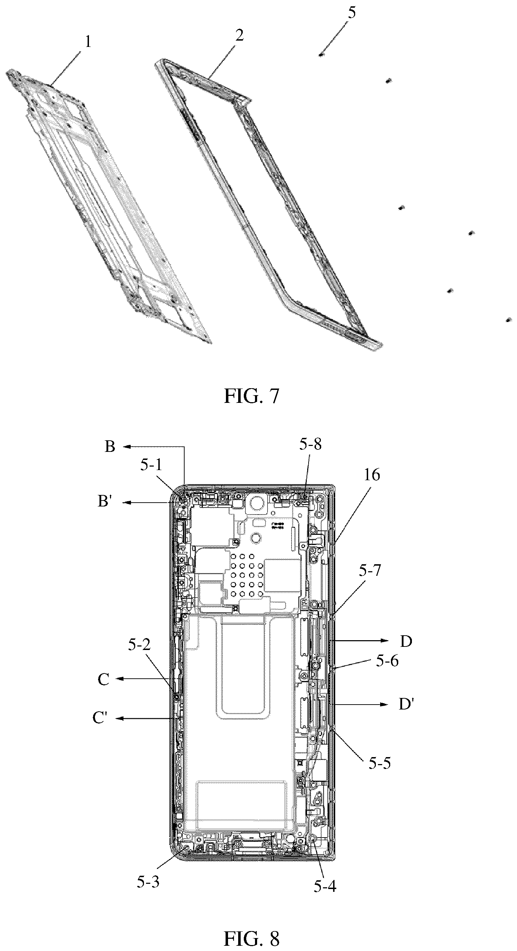

FIG. 7 is a schematic diagram of mounting of a fastening member 5 of the middle frame assembly 20 according to an implementation of the present disclosure. In some implementations, as shown in FIG. 7, to firmly fix the inner frame 1 and the outer frame 2 to ensure combination strength between the inner frame 1 and the outer frame 2, the inner frame 1 and the outer frame 2 may be further fastened by a fastening member 5.

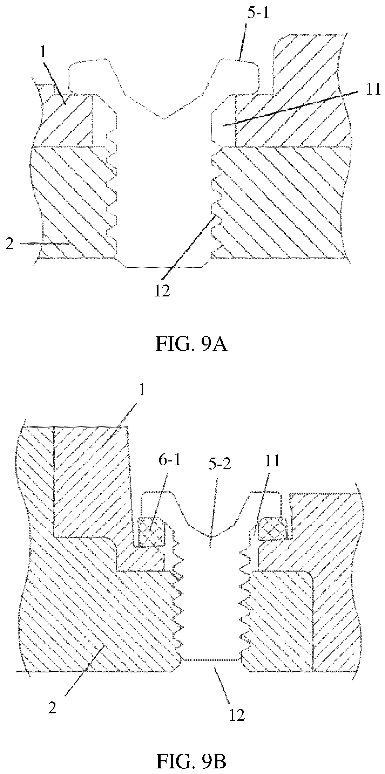

For example, the fastening member 5 may be a locking screw, a screw, a rivet, or the like, but is not limited thereto. In the following implementations of FIG. 8 to FIG. 9D, a locking screw is used as an example for description.

In some implementations, the fastening members 5 are arranged on an edge of the middle frame assembly 20 at intervals. Such a structure can ensure sufficient bonding strength between the inner frame and the outer frame. For example, the fastening members 5 are arranged at corners and middle parts of the middle frame assembly 20, and a quantity of the fastening members 5 may be greater than or equal to 6, but the present disclosure is not limited thereto.

The inner frame 1 and the outer frame 2 may be combined by the fastening members 5 in various manners. FIG. 8 is a plan view of an example of a fastening member of a middle frame assembly according to an implementation of the present disclosure. In FIG. 8, the fastening members 5 include eight locking screws 5-1 to 5-8. The locking screws 5-1, 5-3, 5-4, and 5-8 directly lock the inner frame 1 and the outer frame 2, the locking screw 5-2 locks the inner frame 1 and the outer frame 2 to a support structural member, and the locking screws 5-5, 5-6, and 5-7 lock the inner frame 1 and the outer frame 2 to a rotating shaft structural member.

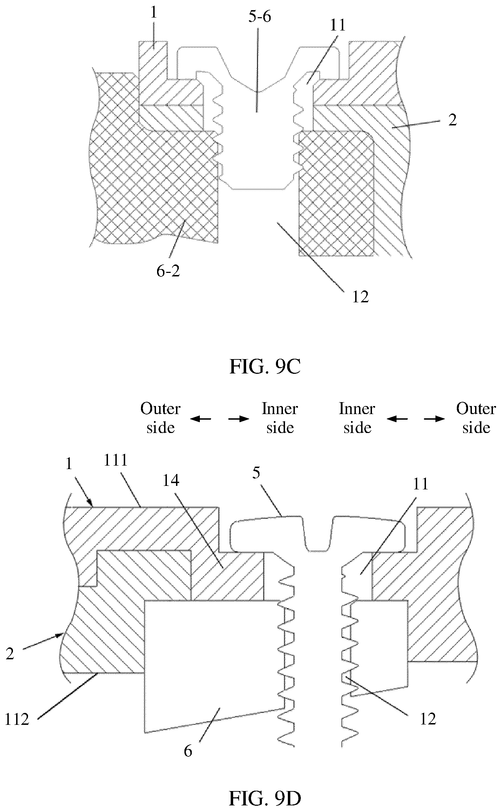

FIG. 9A is a cross-sectional view taken along a line B-B' in FIG. 8. FIG. 9B is a cross-sectional view taken along a line C-C' in FIG. 8. FIG. 9C is a cross-sectional view taken along a line D-D' in FIG. 8.

As shown in FIG. 9A to FIG. 9C, at least one of the inner frame 1 and the outer frame 2 may be provided with through holes 11, and the locking screws 5-1, 5-2, and 5-6 pass through the through holes 11 to fix the inner frame 1 and the outer frame 2.

Specifically, in FIG. 9A, the inner frame 1 is provided with a through hole 11, the outer frame 2 is provided with a threaded hole 12, the locking screw 5-1 passes through the through hole 11 from the inner frame 1 and is fixed to the threaded hole 12, that is, is fixed to the outer frame 2, and a nut of the locking screw 5-1 is pressed on an upper surface of the inner frame 1.

Similarly, alternatively, the outer frame 2 is provided with a through hole 11, the inner frame 1 is provided with a threaded hole 12, the locking screw 5-1 passes through the through hole 11 from the outer frame 2 and is fixed to the inner frame 1, and a nut of the locking screw 5-1 is pressed on an upper surface of the outer frame 2 (not shown).

In FIG. 9A, the inner frame 1 and the outer frame 2 are fastened by the locking screws 5-1 without using any other structural member, so that firm fixing is performed by using fewer components, and the process is simple.

In FIG. 9B and FIG. 9C, the locking screws 5-2 and 5-6 may respectively fix the inner frame 1 and the outer frame 2 together to a support structural member 6-1 and a rotating shaft structural member 6-2 combined with the middle frame assembly 20. In FIG. 9B and FIG. 9C, in addition to the inner frame 1 and the outer frame 2, the support structural member 6-1 and the rotating shaft structural member 6-2 of the electronic device are further respectively used, so that the inner frame 1, the outer frame 2, and the structural members 6-1 and 6-2 can be fastened more firmly by the locking screws 5-2 and 5-6 respectively. The support structural member 6-1 and the rotating shaft structural member 6-2 are not parts of the inner frame 1 or the outer frame 2, but are components of the electronic device. In addition, in the support structural member 6-1 and the rotating shaft structural member 6-2 of the electronic device, for ease of connection, the support structural member 6-1 and the rotating shaft structural member 6-2 are often provided with mounting holes, so that addition of an unnecessary part is avoided, a machining process can be simplified, and costs can also be reduced.

A structural member combined with the middle frame assembly 20 may be one layer of structural member, or may be a plurality of stacked structural members. The structural member may include the support structural member 6-1 shown in FIG. 9B, the rotating shaft structural member 6-2 shown in FIG. 9C, a PCB board, or the like, but is not limited thereto. The structural member may alternatively be another structural member. Because the structural member fastened to the middle frame member may be various structural member of the electronic device such as a support structural member, a rotating shaft structural member, or a PCB board, fastening manners are diversified according to different structural members and fastened parts, thereby increasing flexibility of fastening between the middle frame assembly and the structural member and saving space, to achieve structural compactness.

In FIG. 9B, the support structural member 6-1 and the inner frame 1 are provided with through holes 11, the outer frame 2 is provided with a threaded hole 12, and the locking screw 5-2 passes through the through holes 11 and is fixed to the outer frame 2.

Because the locking screws 5-2 can fix the support structural member 6-1 on the middle frame assembly 20, and can also fix the inner frame 1 and the outer frame 2, addition of an unnecessary part is avoided, a machining process can be simplified, and costs can also be reduced.

The support structural member 6-1 may be, for example, a fingerprint support configured to fix a fingerprint module, a main board support configured to support a main board, or the like, but is not limited thereto.

Referring to FIG. 8 and FIG. 9C, an embodiment of the present disclosure discloses an example of combining the middle frame assembly 20 and the rotating shaft structural member 6-2, applied to a foldable-display mobile phone. The rotating shaft structural member 6-2 is configured to implement folding of the foldable-display mobile phone. However, this implementations of the present disclosure may also be applied to a non-foldable-display mobile phone or another electronic device.

In FIG. 9C, the inner frame 1 and the outer frame 2 are provided with through holes 11, the rotating shaft structural member 6-2 below the outer frame 2 is provided with a mounting hole (used as a threaded hole) 12, and the locking screw 5-6 passes through the through holes 11 and is fixed to the structural member 6-2. Because the locking screws 5-6 can fix the rotating shaft structural member 6-2 on the middle frame assembly 20, and can also fix the inner frame 1 and the outer frame 2, addition of an unnecessary part is avoided, a machining process can be simplified, and costs can also be reduced. Similarly, a structural member above the inner frame 1 is provided with a threaded hole, and the locking screw 5-6 may also be fixed to the structural member (not shown) above the inner frame 1 through the through holes 11.

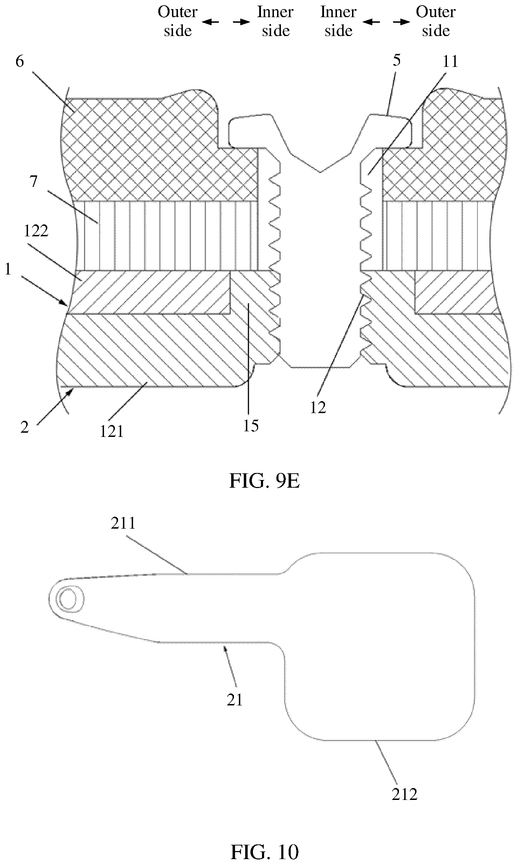

A connection manner of the fastening member of the present disclosure is not limited to the foregoing embodiments of FIG. 8, FIG. 9A, and FIG. 9C, but may alternatively be another connection manner. For example, FIG. 9D is a schematic diagram of another connection manner of the fastening member according to an implementation of the present disclosure. FIG. 9E is a schematic diagram of still another connection manner of the fastening member according to an implementation of the present disclosure, but the present disclosure is not limited thereto.

In FIG. 9D to FIG. 9E, the locking screw 5 may fix the inner frame 1 and the outer frame 2 together to a structural member combined with the middle frame assembly 20. In FIG. 9D to FIG. 9E, in addition to the inner frame 1 and the outer frame 2, a structural member of the electronic device is further used, so that the inner frame 1, the outer frame 2, and the structural member can be fastened more firmly by the locking screw 5. A structural member 6 is a part of the inner frame 1 or the outer frame 2, and is a component of the electronic device. In addition, in the structural member of the electronic device, for ease of connection, the structural member is often provided with a mounting hole, so that addition of an unnecessary procedure is avoided, a machining process can be simplified, and costs can also be reduced.

In the present disclosure, the inner frame 1 and the outer frame 2 may be interlocked together in a concave-convex manner, as shown in FIG. 9D and FIG. 9E, but are not limited thereto.

In FIG. 9D, similar to FIG. 9B, an example in which the structural member 6 is a rotating shaft structural member is used, but the present disclosure is not limited thereto. The inner frame 1 and the outer frame 2 are provided with through holes 11, and the structural member 6 is provided with a threaded hole 12. In FIG. 9D, the inner frame 1 has a concave portion 111, and the outer frame 2 has a convex portion 112 interlocked with the concave portion 111.

Specifically, the inner frame 1 is provided with the through hole 11, the structural member 6 is provided with the threaded hole 12, and the fastening member 5 passes through the through hole 11 and is fastened into the threaded hole 12, so that the inner frame 1 is fastened together with the structural member 6 by the fastening member 5, and the convex portion 112 of the outer frame 2 is clamped between the structural member 6 and the concave portion 121 of the inner frame 1 by a fastening force applied by the fastening member 5. Although FIG. 9D shows an embodiment in which the convex portion 112 of the outer frame 2 is clamped between the structural member 6 and the concave portion 121 of the inner frame 1, the embodiment is not limited thereto. Alternatively, the inner frame 1 has a convex portion, the outer frame 2 has a concave portion interlocked with the convex portion of the inner frame 1, and the convex portion of the inner frame 1 is clamped between the structural member 6 and the concave portion of the outer frame 2. Alternatively, although not shown in the accompanying drawings, a concave portion of one of the inner frame 1 and the outer frame 2 may be clamped between the structural member 6 and a convex portion of the other of the inner frame 1 and the outer frame 2.

Due to use of a concave-convex interlocking structure of the inner frame and the outer frame, accurate alignment can be easily achieved when the inner frame and the outer frame are fastened, the inner frame or the outer frame from being misaligned when the fastening member is fastened, and the inner frame and the outer frame can be fastened together more firmly.

As shown in FIG. 9D, a size of the threaded hole 12 of the outer frame 2 is greater than a size of the through hole 11 of the inner frame 1, so that the outer frame and the inner frame can be easily interlocked in a concave-convex manner, but the implementation is not limited thereto.

It can be learned from FIG. 9D that the inner frame 1 is closer to the locking screw 5 than the convex portion 112 of the outer frame 2. Sides of the inner frame 1 and the outer frame 2 close to the locking screws 5 are referred to as inner sides of the inner frame 1 and the outer frame 2, and sides of the inner frame 1 and the outer frame 2 away from the locking screws 5 are referred to as outer sides of the inner frame 1 and the outer frame 2. That is, the locking screw 5 is not in contact with the convex portion 112 of the outer frame 2.

In the example shown in FIG. 9D, the inner frame 1 is closer to the locking screw 5 than the convex portion 112 of the outer frame 2, which is consistent with that the outer frame 2, as shown in FIG. 3 of the present disclosure, is arranged on an outer periphery of the inner frame 1.

Similarly, alternatively, the inner frame 1 is further away from the locking screw 5 than the outer frame 2. In this case, a size of the through hole 11 of the inner frame 1 is greater than a size of the threaded hole 12 of the outer frame 2 (not shown).

In FIG. 9E, similar to FIG. 9A, the inner frame 1 is provided with a through hole 11, the outer frame 2 is provided with a threaded hole 12, the locking screw 5 passes through the through hole 11 from the inner frame 1 and is fixed to the threaded hole 12, that is, is fixed to the outer frame 2, and a nut of the locking screw 5 is pressed on an upper surface of the inner frame 1.

Different from FIG. 9A, FIG. 9E shows that two layers of structural members are arranged on upper sides of the inner frame 1 and the outer frame 2. An example in which a structural member 6 is a support structural member and a structural member 7 is a PCB board is used, but the present disclosure is not limited thereto. In FIG. 9E, a first structural member 7 located on an upper side of the inner frame 1, a second structural member 6 located on an upper side of the first structural member 7, and the inner frame 1 are all provided with through holes 11, and the outer frame 2 is provided with a threaded hole 12.

In FIG. 9E, the outer frame 2 has a concave portion 121, and the inner frame 1 has a convex portion 122 interlocked with the concave portion 121. The outer frame 2 extends into the through hole 12 of the inner frame 1.

Specifically, the outer frame 2 is provided with the threaded hole 12, the inner frame 1 and the structural members 6 and 7 are provided with the through holes 11, and the fastening member 5 passes through the through holes 11 and is fastened into the threaded hole 12, so that the outer frame 2 is fastened together with the structural members 6 and 7 by the fastening member 5, and the convex portion 122 is clamped between the structural members 6 and 7 and the concave portion 121 by a fastening force applied by the fastening member 5.

Due to use of a concave-convex interlocking structure of the inner frame and the outer frame, accurate alignment can be easily achieved when the inner frame and the outer frame are fastened, the inner frame or the outer frame from being misaligned when the fastening member is fastened, and the inner frame and the outer frame can be fastened together more firmly.

The locking screw 5 passes through the through holes 11 and is fixed to the threaded hole 12, that is, fixed to the outer frame 2, so that a size of the through hole 11 of the inner frame 1 is greater than a size of the through hole 11 of the outer frame 2, but the implementation is not limited thereto.

It can be learned from FIG. 9E that the outer frame 2 is closer to the locking screw 5 than the convex portion 122 of the inner frame 1. Sides of the inner frame 1 and the outer frame 2 close to the locking screws 5 are referred to as inner sides of the inner frame 1 and the outer frame 2, and sides of the inner frame 1 and the outer frame 2 away from the locking screws 5 are referred to as outer sides of the inner frame 1 and the outer frame 2. That is, the locking screw 5 is not in contact with the inner frame 1, but is only in contact with the outer frame 2.

In FIG. 9E, the outer frame 2 is closer to the locking screw 5 than the convex portion 122 of the inner frame 1, which is not contradictory with that the outer frame 2, as shown in FIG. 3 of the present disclosure, is arranged on an outer periphery of the inner frame 1. That is, the outer frame 2 is entirely arranged on the outer periphery the inner frame 1. However, in a partial region, there may also be a case in which the inner frame 1 and the outer frame 2 are interlocked together in a concave-convex manner, and a part of the outer frame 2 may be on the inner side of the inner frame 1.

Although FIG. 9E shows two layers of structural members, that is, the first structural member 7 and the second structural member 6, the present disclosure is not limited thereto. The structural member combined with the middle frame assembly 20 may alternatively be a one layer of structural member or three or more layers of structural members (not shown).

Alternatively, the structural member combined with the middle frame assembly 20 may be a structural member (not shown) located on a lower side of the outer frame 1, or the structural members combined with the middle frame assembly 20 may be structural members on an upper side of the inner frame 1 and a lower side of the outer frame 2 respectively.

Similarly, alternatively, the outer frame 2 is further away from the locking screw 5 than the inner frame 1. In this case, a size of the through hole 11 of the outer frame 2 is greater than a size of the through hole 11 of the inner frame 1 (not shown). In this case, at a position around the through hole 11, the locking screw 5 is not in contact with the inner frame 1, but is only in contact with the outer frame 2.

As shown in FIG. 9A to FIG. 9E, a hole diameter of the through hole 11 may be greater than a hole diameter of the threaded hole 12, so that the locking screw passes through the through hole more easily.

In the same electronic device, it is not limited to use of only one of the fastening members in FIG. 9A to FIG. 9E, and instead, any one or more of the fastening members in FIG. 9A to FIG. 9E may be combined according to a specific case of the electronic device. For example, when there is no structural member at one or more of positions of the electronic device at which the fastening member 5 needs to be mounted, the inner frame 1 and the outer frame 2 may be firmly fastened by the fastening member 5. When there is a structural member at one or more of the positions of the electronic device at which the fastening member 5 needs to be mounted, the inner frame 1, the outer frame 2, and the structural member may be firmly fastened by the fastening member 5.

In some implementations, one or both of the inner frame 1 and the outer frame 2 may further include a plastic layer, to achieve an antenna clearance effect.

For example, the inner frame 1 may further include a first plastic layer (not shown), and the first metal material and the first plastic layer may be combined by in-mold injection molding. The outer frame 2 may further include a second plastic layer (not shown), and the second metal material and the second plastic layer may be combined by nano-injection molding.

Because the first metal material of the inner frame and the first plastic layer are combined by in-film injection molding, the first plastic layer and the first metal material can be reliably combined, thereby ensuring stability and durability of the combination. In addition, the second metal material of the outer frame is combined with the second plastic layer by nano-injection molding. Because metal and plastic are mutually combined at the nano level, the combination strength is greatly improved, thereby improving the mechanical performance. In addition, since formation can be performed by one-shot injection molding, two or more machining procedures originally required are omitted, so that a process can be simplified, a production cycle can be shortened, and productivity can be improved. In addition, due to use of nano-injection molding, not only a metallic appearance texture is achieved, to improve the aesthetics, but also the structural member is more secure.

One or both of the first plastic layer and the second plastic layer is made of a plastic material, for example, polycarbonate (PC), acrylonitrile-butadiene-styrene plastic (ABS), glass fiber reinforced polycarbonate (PC+GF), ABS reinforced polycarbonate (ABS+PC), or a carbon fiber reinforced resin composite material.

The first plastic layer and the second plastic layer may be closed annular structures or semi-closed annular structures. For example, the first plastic layer and the second plastic layer are half-frame structures located in a clearance area of a radiator of an antenna. The first plastic layer may be located on one or both of the inner side and the outer side of the inner frame 1, and the second plastic layer may be located on one or both of the inner side and the outer side of the outer frame 2, but the present disclosure is not limited thereto.

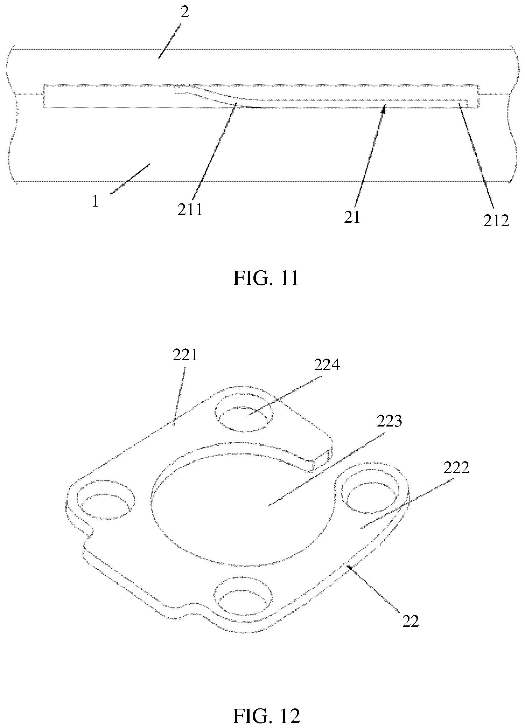

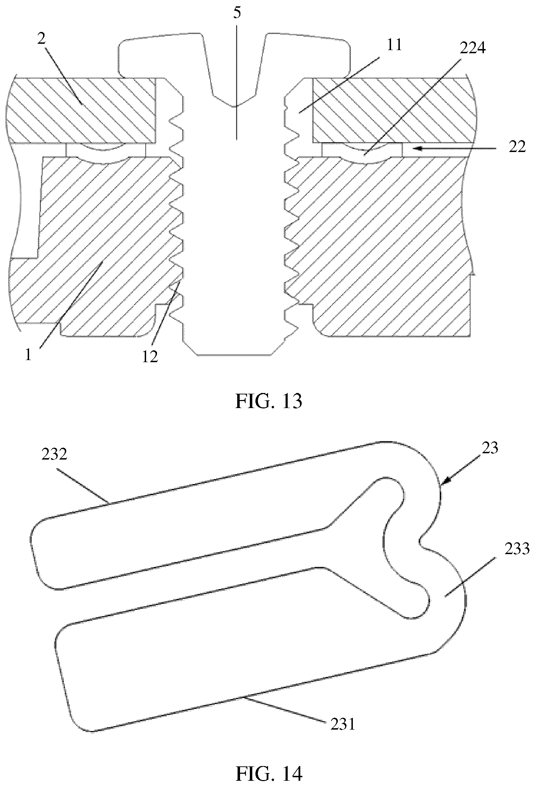

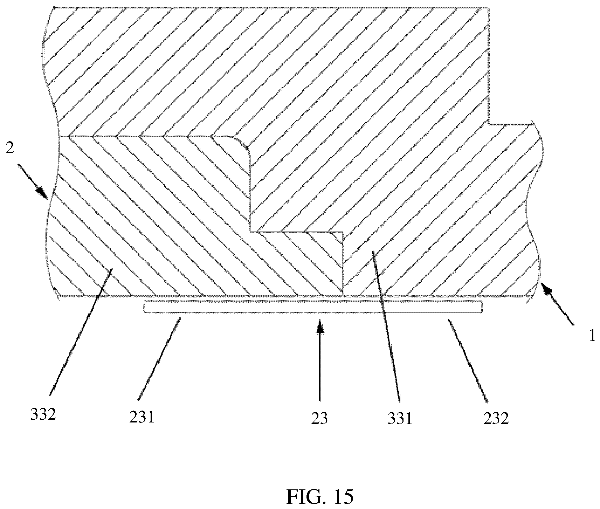

In addition, in the mobile phone 100, unstable contact between metal and metal causes interference to performance of the antenna, and contact between metal of the inner frame 1 and metal of the outer frame 2 is such unstable contact. Therefore, the outer frame 2 and the inner frame 1 may be electrically connected to each other by a conductive member, to ensure a stable electrical connection between the inner frame 1 and the outer frame 2, thereby achieving a stable electrical connection. The conductive member is, for example, an elastic piece shown in FIG. 10 and FIG. 11, a gasket shown in FIG. 12 and FIG. 13, and a connecting piece shown in FIG. 14 and FIG. 15, but is not limited thereto, provided that a stable electrical connection between the inner frame 1 and the outer frame 2 can be ensured.

A material of the conductive member is, for example, a metal such as copper (Cu), but is not limited thereto, provided that the material is a material capable of conducting electricity.

FIG. 10 is a schematic diagram of an elastic piece 21 according to an implementation of the present disclosure, and FIG. 11 is a schematic diagram of an elastic piece being mounted between an inner frame and an outer frame according to an implementation of the present disclosure.

As shown in FIG. 10, the conductive member is an elastic piece 21, and the elastic piece 21 is made of an elastic material with conductivity. The elastic piece 21 includes an elastic piece base 212 and an elastic piece probe 211 extending from the elastic piece base 212. As shown in FIG. 11, the elastic piece 21 is fixed between the inner frame 1 and the outer frame 2, the elastic piece base 212 is in contact with the inner frame 1, and the elastic piece probe 211 is in contact with the outer frame 2. Alternatively, although not shown in the accompanying drawings, the elastic piece base 212 may alternatively be in contact with the outer frame 2, and in this case, the elastic piece probe 211 is in contact with the inner frame 1.

Preferably, as shown in FIG. 11, the elastic piece base 212 of the elastic piece 21 may be welded to the inner frame 1. In this case, the elastic piece probe 211 of the elastic piece 21 abuts against the outer frame 2. Because the elastic piece 21 is elastic, a stable electrical connection between the inner frame 1 and the outer frame 2 is ensured. Alternatively, although not shown in the accompanying drawings, the elastic piece base 212 of the elastic piece 21 may alternatively be welded to the outer frame 2, and the elastic piece probe 211 of the elastic piece 21 abuts against the inner frame 1, so that a stable electrical connection between the inner frame 1 and the outer frame 2 can also be ensured.

As described above with reference to FIG. 5A and FIG. 5B, the adhesive layer 4 closes a gap between the inner frame 1 and the outer frame 2. In this implementation, the adhesive layer 4 is arranged between the inner frame 1 and the outer frame 2 at other positions other than the elastic piece 21, thereby ensuring tight sealing between the inner frame 1 and the outer frame 2 while ensuring the electrical connection between the inner frame 1 and the outer frame 2. That is, the adhesive layer 4 is not coated at a position at which the elastic piece 21 is arranged. Similar to the elastic piece 21 in FIG. 10 and FIG. 11, when the gasket 22 and the connecting piece 23 in the following are arranged between the inner frame 1 and the outer frame 2, the adhesive layer 4 is not coated at arrangement positions thereof.

FIG. 12 is a schematic diagram of a gasket 22 according to an implementation of the present disclosure, and FIG. 13 is a schematic diagram of a gasket being mounted between an inner frame and an outer frame according to an implementation of the present disclosure.

As shown in FIG. 12 and FIG. 13, the conductive member is a gasket 22, and the gasket 22 is arranged between the inner frame 1 and the outer frame 2.

As shown in FIG. 12, the gasket 22 includes a gasket body 221 and a gasket elastic arm 222 extending from the gasket body 221. The gasket body 221 and the gasket extension arm 222 enclose a non-closed ring shape, and a hollow portion 223 is formed in the ring shape. Gasket bumps 224 are arranged on at least one of upper surfaces and lower surfaces of the gasket body 221 and the gasket elastic arm 222. At least two gasket bumps 224 may be arranged. To be specific, there is one gasket bump 224 on the gasket elastic arm 222, and there may be one or more gasket bumps 224 on the gasket body 221. For example, as shown in FIG. 12, four gasket bumps 224 may be arranged, respectively located at three corners of the gasket body 221 and a top end of the gasket elastic arm 222, but are not limited thereto.

The gasket bumps 224 may be arranged on both the upper surfaces and the lower surfaces of the gasket body 221 and the gasket elastic arm 222, and abut against the inner frame 1 and the outer frame 2 respectively, to ensure a stable electrical connection between the inner frame 1 and the outer frame 2. Generally, the gasket bumps 224 are formed through a process such as stamping. Therefore, in a case that the gasket bumps 224 can be arranged on both the upper surfaces and the lower surfaces of the gasket body 221 and the gasket elastic arm 222, the gasket bumps 224 on the upper surfaces are arranged at positions different from those at which the gasket bumps 224 on the lower surfaces are arranged.

Alternatively, the gasket bumps 224 may be arranged on one of the upper surfaces and the lower surfaces of the gasket body 221 and the gasket elastic arm 222. For example, the gasket bumps 224 may be arranged on the upper surfaces of the gasket body 221 and the gasket elastic arm 222 to come into contact with one of the inner frame 1 and the outer frame 2. In this case, the lower surface of the gasket body 221 is welded to the other of the inner frame 1 and the outer frame 2, and the lower surface of the elastic arm 222 is not welded to the other of the inner frame 1 and the outer frame 2, to ensure elastic contact between the inner frame 1 and the outer frame 2, thereby avoiding an unstable electrical connection caused by direct hard contact between the inner frame 1 and the outer frame 2, and ensuring a stable electrical connection between the inner frame 1 and the outer frame 2. Alternatively, referring to FIG. 13, the gasket bumps 224 may be arranged on the lower surfaces of the gasket body 221 and the gasket elastic arm 222 to come into contact with one (which is shown as the outer frame 2 in FIG. 3, but is not limited thereto) of the inner frame 1 and the outer frame 2. In this case, the upper surface of the gasket body 221 is welded to the inner frame 1, and the upper surface of the elastic arm 222 is not welded to the inner frame 1.

FIG. 13 shows an example in which the gasket bumps 224 are mounted between the inner frame 1 and the outer frame 2 in a case that the gasket bumps 224 are arranged only on the lower surfaces of the gasket body 221 and the gasket elastic arm 222. As shown in FIG. 13, the gasket 22 is sandwiched between the inner frame 1 and the outer frame 2 by the fastening member 5. Specifically, the gasket 22 is arranged between the inner frame 1 and the outer frame 2, and then, the fastening member 5 passes through the hollow region 223 of the gasket 22. In this case, the gasket body 221 and the gasket elastic arm 222 surround the fastening member 5, to abut the gasket bumps 224 against the inner frame 1. Therefore, when the inner frame 1 and the outer frame 2 are fastened by the fastening member 5, the gasket 22 can also be reliably abutted against the inner frame 1 and the outer frame 2, thereby ensuring a stable electrical connection between the inner frame 1 and the outer frame 2. As shown in FIG. 13, for example, the gasket bumps 224 may be formed through a process such as stamping. If the gasket bumps 224 are arranged on a lower surface of the gasket 22, an upper surface of the gasket 22 is recessed accordingly.

FIG. 14 is a schematic diagram of a connecting piece 23 according to an implementation of the present disclosure, and FIG. 15 is a schematic diagram of a connecting piece being mounted between an inner frame and an outer frame according to an implementation of the present disclosure.

As shown in FIG. 14 and FIG. 15, the conductive member is a connecting piece 23. The connecting piece 23 includes a first arm 231, a second arm 232 spaced apart from the first arm 231 by a gap and opposite to the first arm 231, and a connecting portion 233 connecting the first arm 231 and the second arm 232. The first arm 231 and the second arm 232 respectively extend from the connecting portion 232. The connecting portion 232 may be in a bent shape shown in FIG. 14, but is not limited thereto. The connecting portion 232 may alternatively be in any other shape, provided that the first arm 231 and the second arm 232 can be connected.

The first arm 231 may be connected to the inner frame 1, and the second arm 232 may be connected to the outer frame 2. Preferably, the first arm 231 may be welded to the inner frame 1, and the second arm 232 may be welded to the outer frame 2, but the present disclosure is not limited thereto.

For example, the inner frame 1 and the outer frame 2 may be interlocked in a concave-convex manner. In particular, in a region connected to the connecting piece 23, the inner frame 1 has a recessed portion or a protruding portion, and the outer frame 2 has a protruding portion or a recessed portion interlocked with the recessed portion or the protruding portion.

For example, as shown in FIG. 15, the inner frame 1 has a recessed portion 331. The outer frame 2 has a protruding portion 332 interlocked with the recessed portion 331. The connecting piece 23 is arranged on a same side of the inner frame 1 and the outer frame 2, the first arm 231 may be welded to the outer frame 2, and the second arm 232 may be welded to the inner frame 1. However, the present disclosure is not limited thereto.

Due to a concave-convex interlocking structure of the inner frame 1 and the outer frame 2, accurate alignment can be easily achieved, and the inner frame 1 and the outer frame 2 can be effectively prevented from being misaligned during mounting of the connecting piece 23.

Alternatively, the connecting piece 23 may be arranged in any manner. For example, the connecting piece 23 may be arranged between the inner frame 1 and the outer frame 2, the first arm 231 is welded to the outer frame 2, and the second arm 232 is welded to the inner frame 1, provided that a stable electrical connection between the inner frame 1 and the outer frame 2 is ensured.

In some implementations, an electronic device is disclosed, including the foregoing middle frame assembly. The electronic device may be any electronic device, for example, an electronic device having a display function, a communication function, and/or a storage function. The electronic device, for example, may be a smartphone, a cellular phone, a cordless phone, a session initiation protocol (session initiation protocol, SIP) phone, a tablet computer, a personal digital assistant (personal digital assistant, PDA), a notebook computer, a digital camera, an e-book reader, a portable multimedia player, a handheld device having a wireless communication function, a computing device or another processing device connected to a wireless modem, an in-vehicle device, a wearable device, a 5G terminal device, or the like. This is not limited in the present disclosure. According to implementations of the present disclosure, a weight of the middle frame assembly can be reduced, and further, a weight of the electronic device can be reduced, thereby improving portability.

The preferred implementations of the present disclosure are described in detail above with reference to the accompanying drawings. However, the present disclosure is not limited to the specific details in the foregoing implementations, a plurality of simple deformations may be made to the technical solution of the present disclosure within a range of the technical concept of the present disclosure, and these simple deformations fall within the protection scope of the present disclosure.

## Claims

1. A middle frame assembly, comprising an inner frame and an outer frame arranged on an outer periphery of the inner frame, wherein the inner frame comprises a first metal material, the outer frame comprises a second metal material, and a density of the first metal material is lower than a density of the second metal material.

2. The middle frame assembly according to claim 1, wherein the density of the first metal material is lower than or equal to 70% of the density of the second metal material.

3. The middle frame assembly according to claim 1, wherein the first metal material of the inner frame comprises one or more selected from a magnesium alloy, a zinc alloy, and a copper alloy.

4. The middle frame assembly according to claim 1, wherein the second metal material of the outer frame comprises one or more selected from an aluminum alloy, stainless steel, and a titanium alloy.

5. The middle frame assembly according to claim 4, wherein the second metal material is arranged on an outer surface of the outer frame.

6. The middle frame assembly according to claim 1, wherein one or both of the inner frame and the outer frame is a single-layer frame.

7. The middle frame assembly according to claim 1, wherein one or both of the inner frame and the outer frame is a laminated frame having a multi-layer structure.

8. The middle frame assembly according to claim 1, wherein an adhesive layer is arranged between the inner frame and the outer frame.

9. The middle frame assembly according to claim 8, wherein a part at which the inner frame and the outer frame have a height difference is arranged in a ramp shape, and the adhesive layer is arranged on the ramp-shaped part.

10. The middle frame assembly according to claim 8, wherein the inner frame and the outer frame are fastened by a fastening member.

11. The middle frame assembly according to claim 10, wherein the fastening member is a locking screw, at least one of the inner frame and the outer frame is provided with a through hole, and the fastening member passes through the through hole to fix the inner frame and the outer frame.

12. The middle frame assembly according to claim 11, wherein one of the inner frame and the outer frame is provided with the through hole, the other of the inner frame and the outer frame is provided with a threaded hole, and the fastening member passes through the through hole and is fastened into the threaded hole.

13. The middle frame assembly according to claim 1, wherein a conductive member electrically connecting the outer frame and the inner frame is provided between the outer frame and the inner frame.

14. The middle frame assembly according to claim 13, wherein the conductive member is an elastic piece, and the elastic piece comprises an elastic piece base and an elastic piece probe extending from the elastic piece base, wherein the elastic piece base is in contact with one of the inner frame and the outer frame, and the elastic piece probe is in contact with the other of the inner frame and the outer frame.

15. The middle frame assembly according to claim 14, wherein the elastic piece base is welded to the one of the inner frame and the outer frame, and the elastic piece probe abuts against the other of the inner frame and the outer frame.

16. The middle frame assembly according to claim 13, wherein the conductive member is a gasket, and the gasket comprises a gasket body and a gasket elastic arm extending from the gasket body, wherein a gasket bump is arranged on at least one of an upper surface and a lower surface of the gasket body, and the gasket bump is arranged on at least one of an upper surface and a lower surface of the gasket elastic arm; and
the gasket is sandwiched between the inner frame and the outer frame through a fastening member, the gasket body and the gasket elastic arm surround the fastening member, and the gasket bump abuts against at least one of the inner frame and the outer frame.

17. The middle frame assembly according to claim 16, wherein the gasket bumps are arranged on the upper surfaces and the lower surfaces of the gasket body and the gasket elastic arm, and abut against the inner frame and the outer frame respectively, and the gasket bumps are arranged at different positions respectively on the upper surfaces of the gasket body and the gasket elastic arm and the lower surfaces of the gasket body and the gasket elastic arm; or
the gasket bumps are arranged on only the upper surfaces of the gasket body and the gasket elastic arm, and the lower surface of the gasket body on which no gasket bump is arranged is welded to the inner frame or the outer frame; or
the gasket bumps are arranged on only the lower surfaces of the gasket body and the gasket elastic arm, and the upper surface of the gasket body on which no gasket bump is arranged is welded to the inner frame or the outer frame.

18. The middle frame assembly according to claim 13, wherein the conductive member is a connecting piece, and the connecting piece comprises a first arm, a second arm spaced apart from the first arm by a gap and opposite to the first arm, and a connecting portion connecting the first arm and the second arm, wherein first arm and the second arm respectively extend from the connecting portion, the first arm is connected to the inner frame, and the second arm is connected to the outer frame.

19. The middle frame assembly according to claim 18, wherein in a region connected to the connecting piece, the inner frame has a recessed portion or a protruding portion, and the outer frame has a protruding portion or a recessed portion interlocked with the recessed portion or the protruding portion.

20. An electronic device, comprising:
the middle frame assembly according to any one of claims 1 to 19.

21. An electronic device, comprising:
the middle frame assembly according to any one of claims 1 to 19;
a structural member of the electronic device; and
a fastening member, wherein the inner frame and the outer frame are combined with the structural member by the fastening member.

22. The electronic device according to claim 21, wherein one of the inner frame and the outer frame and the structural member are provided with through holes, the other of the inner frame and the outer frame is provided with a threaded hole, and the fastening member passes through the through holes and is fastened into the threaded hole.

23. The electronic device according to claim 21, wherein the structural member is provided with a threaded hole, the inner frame and the outer frame are both provided with through holes, and the fastening member passes through the through holes and is fastened into the threaded hole.

24. The electronic device according to claim 21, wherein one of the inner frame and the outer frame has a concave portion, and the other of the inner frame and the outer frame has a convex portion interlocked with the concave portion; and
at least one of the inner frame and the outer frame is fastened to the structural member by the fastening member, and one of the concave portion and the convex portion is clamped between the structural member and the other of the concave portion and the convex portion.

25. The electronic device according to claim 21, wherein the structural member comprises a plurality of stacked structural members, and the inner frame and the outer frame are fastened to the plurality of structural members by the fastening member.

26. The electronic device according to claim 21, wherein the structural member is a support structural member, a rotating shaft structural member, or a PCB board.
